Europäisches Patentamt

European Patent Office

Office européen des brevets

(11) Publication number: **0 485 075 A1**

# EUROPEAN PATENT APPLICATION

(21) Application number: **91309407.4**

(22) Date of filing: **14.10.91**

(51) Int. Cl.5: **H05K 13/04**

(30) Priority: **06.11.90 GB 9024100**

(43) Date of publication of application:
**13.05.92 Bulletin 92/20**

(84) Designated Contracting States:
**BE CH DE FR GB IT LI NL SE**

(71) Applicant: **EMHART INC.**
**Drummond Plaza Office Park, 1423, Kirkwood Highway**
**Newark, Delaware 19711(US)**

(72) Inventor: **Hawkswell, Victor Thomas**
**42 Highfields Road**
**Witham, Essex(GB)**

(74) Representative: **Stagg, Diana Christine et al**
**Emhart Patents Department Lyn House 39 The Parade**
**Oadby Leicester LE2 5BB(GB)**

(54) **Improved pick-up tool.**

(57) A pick-up tool 2 for a pick and place machine comprises a hollow metal pack-up tool 4 adapted to be fitted to the head of a pick and place machine and a cover 8 for the pick-up tool 4. The cover 8 is made of a hard, wear-resistant, resilient black material and comprises a sleeve portion 10 which is a push-fit on the tool 4, and terminates in a cap portion 12 which covers the free end of the tool 4 and is provided with a central aperture 14 which, when the cover 8 is mounted on the tool 4, is coaxial with the central bore 6 of the tool, through which suction can be applied during the operation of the machine.

The improved tool provides an ideal background for the vision system of the inspection station of a pick and place machine.

The invention relates to an improved pick-up tool for a pick and place machine, for use in particular in surface mount technology. Pick and place machines are widely used for mounting electronic components on substrates, in particular on printed circuit boards, and various designs have been proposed in order to produce the optimum results in terms of reliability, reproducibility and speed of mounting of components.

In a conventional pick and place machine, the tool comprises a hollow steel needle mounted on a head, which tool is driven between a pick-up station at which a component is picked up from a suitable supply means, and a mounting station at which the component is placed on the substrate in a predetermined position. There may also be one or more intermediate stations at which the component may be for example inspected, tested or aligned to a preferred alignment.

Most pick and place machines include an inspection station, at which the component is inspected visually, typically by automatic comparison with a standard image. For the inspection to be carried out, the component must be illuminated and many systems use a reflection system for illumination.

Where the tool on which the component is held is a metal tool, there can often be reflections from the tool which interfere with the vision system; in order to overcome these, it is necessary for the position of the component to be adjusted, for example by tweezering, at a further intermediate station, prior to inspection, in order to optimise the conditions for visual inspection. Attempts have also been made to improve the performance of the tool by coating it with a black coating, but this rapidly wears off.

There is a further problem with known pick-up tools which arises in particular where the components are supplied in a pocketed tape, which is a common means of component supply. In this supply means, when the tool contacts the component in the tape, the downwards pressure of the tool on impact can cause the component to adhere to the lower surface of the tape with the result that a number of components are not picked up, leading to problems in supply of the correct sequence of components to the substrate.

A further problem arises where a variety of differently sized components are being mounted on the same board, and it is necessary to provide a number of differently sized tools to pick them up. It has been proposed to provide multiple tools on each head, but this greatly increases the cost and complexity of the machine. The relative sizes of the tool and component must be closely matched, so that the component can be aligned on the tip of the tool so that the reflective tip of the tool is obscured by the component during inspection. If the tool is too large relative to the component, then it interferes with the vision system at the inspection station. If the tool is too small, then it may not adequately support the component.

It is an object of the present invention to provide a pick-up tool for a pick and place machine in which the above disadvantages are reduced or substantially obviated.

The invention provides a pick-up tool for a pick and place machine which comprises a hollow metal pick-up tool adapted to be fitted to the head of a pick and place machine characterised in that a cover is provided for the pick-up tool, which cover is made of a hard, wear-resistant, resilient black material and comprises a sleeve portion which is a push-fit on the tool, and terminates in a cap portion which covers the free end of the tool and is provided with a central aperture, which when the cover is mounted on the tool, is coaxial with the central bore of the tool, through which suction can be applied during the operation of the machine.

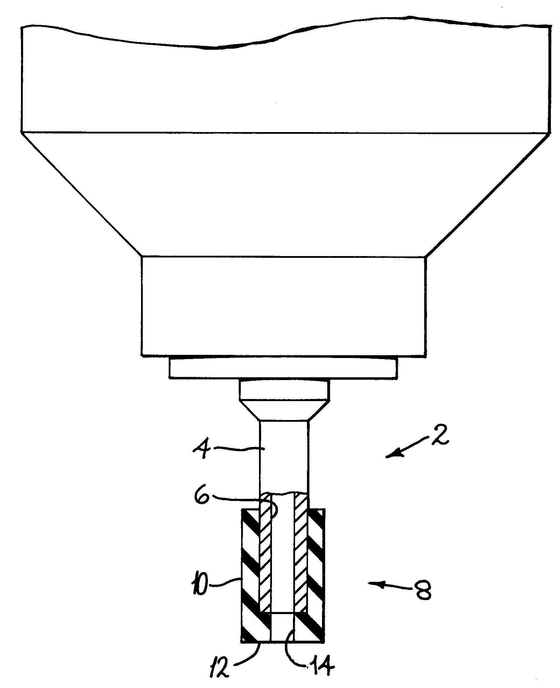

The invention will now be further described with reference to the accompanying drawing, the single figure of which is a view of an embodiment of a pick-up tool according to the invention.

A pick-up tool 2 comprises a metal tool 4 adapted for mounting on the head (not shown) of a pick and place machine. The tool 4 has a central bore 6 through which suction can be applied to the component to be picked up, in order to retain it on the end of the tool. The cover 8 comprises a sleeve portion 10 which terminates in a cap portion 12 with a central aperture 14 which is coaxial with the bore 6 of the tool.

In operation the tool is driven to the pick-up station of the pick and place machine where it picks up a component. Where the component is supplied from a tape, which is a common method of supply, the diameter or the cover is such that the tool does not project into the pocket of the tape, but rests on the surface of the tape and lifts up the component by the application of suction. There is thus no risk of the component being pressed against the base of the pocket and adhering thereto.

The tool is then driven to the inspection station where the component is inspected using a reflection system. The cap portion of the tool cover presents an ideal, black background to the vision system and because it is larger than the component, and provides a black background, the component can be inspected however it is aligned. The tweezering stage of the prior art machine can thus be omitted. The tool is then driven to the placement station; any correction necessary due to the alignment of the component can be determined at the inspection station and made at the placement station.

The cover for the pick-up tool is made from a hard, wear-resistant, resilient black material, for example a hard plasticised rubber. A particularly suitable material has been found to be Desmopan 385/85A Black, a thermoplastic polyurethane manufactured by Bayer A.G., but any material with appropriate wear characteristics may be utilised.

It has in practice been found that a cover made from Desmopan 385/85A has an effective life of about 200 hours operating time, after which it becomes worn and has to be replaced. The cover is an inexpensive component to manufacture, and is easily fitted to and removed from the tool, which means that is replacement does not cause any problems.

If it is desired to place components of different thicknesses on a substrate at close spacing, then it will be found to be advantageous to place the thin components first and then the thick, so that adjacent thick components are not disturbed by the placing of a thin component at a close spacing.

## Claims

1. A pick-up tool 2 for a pick and place machine which comprises a hollow metal pick-up tool 4 adapted to be fitted to the head of a pick and place machine characterised in that a cover 8 is provided for the pick-up tool 4, which cover 8 is made of a hard, wear-resistant, resilient black material and comprises a sleeve portion 10 which is a push-fit on the tool 4, and terminates in a cap portion 12 which covers the free end of the tool 4 and is provided with a central aperture 14 which, when the cover 8 is mounted on the tool 4, is coaxial with the central bore 6 of the tool 4, through which suction can be applied during the operation of the machine.

European Patent
Office

EUROPEAN SEARCH REPORT

Application Number

EP    91 30 9407

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 309 823 (SIEMENS AKTIENGESELLSCHAFT)<br>* claim 1; figure 1 *<br>--- | 1 | H05K13/04 |
| A | US-A-4 793 707 (HATA)<br>* column 1, line 23 - line 45; figure 10 *<br><br>----- | 1 | |
| | | | TECHNICAL FIELDS SEARCHED (Int. Cl.5 )<br><br>H05K |

The present search report has been drawn up for all claims

| Place of search | Date of completion of the search | Examiner |
|---|---|---|
| THE HAGUE | 11 FEBRUARY 1992 | RIEUTORT A.S. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................................................
& : member of the same patent family, corresponding
    document

EPO FORM 1503 03.82 (P0401)